# EUROPEAN PATENT APPLICATION

(11) **EP 0 969 704 A1**
(43) Date of publication of application: **05.01.2000**
(21) Application number: 99111785.4
(22) Date of filing: 18.06.1999
(51) Int. Cl.: H05K 3/30

(54) **Method for reversibly bonding electronics packages in thermal and electrical contact with a surface**

(30) Priority: 18.06.1998 US 99829
(71) Applicant: TRW Inc., Redondo Beach, California 90278 (US)
(72) Inventor: Bjorndahl, William D, Torrance,CA 90505 (US); Chen, Wennei Y, Torrance,CA 90505 (US)
(74) Representative: Schmidt, Steffen J., Dipl.-Ing.

(57) **Abstract**

A method for mounting electronics packages (12, 14) to a heat dissipating panel (24) in such a manner that they can be removed non-destructively if necessary, for replacement or re-working. Critical to the method is the selection of an adhesive (40) that has good electrical and thermal conductivity properties, and also has a glass transition temperature below room temperature. The latter property makes the adhesive re-workable after curing, but without having to heat the components to reverse the bonding process. Adhesives have a relatively low modulus or elasticity above their glass transition temperature. Therefore, the adhesive selected in accordance with the method can be re-worked at room temperature, and the bond can, therefore, be broken without applying large forces to the components and without having to reheat the components.

## Description

### BACKGROUND OF THE INVENTION

This invention relates generally to electronics assembly techniques and, more specifically, to the assembly of relatively costly electronics components onto panels and circuit boards. In a variety of applications being developed or proposed, electronics packages are both powerful and costly. For example, packages including application-specific integrated circuits (ASICs) provide highly efficient processing or logical state machines, but at the expense of relatively high development and fabrication costs. Moreover, such packages have large heat dissipation requirements. Ideally, the packages must be mounted in good thermal contact with a heat sink. Conductive adhesives provide good electrical and thermal contact with a panel that acts as a heat conductor, but adhesives available in the past have not been re-workable at room temperature. Reworking and removing adhesives at elevated temperatures may damage the electronics packages. Attempts to remove defective packages at room temperature are likely to cause mechanical damage, so there is a high probability that the expensive electronics packages cannot be removed safely to permit reworking or repair. The present invention solves this problem.

### SUMMARY OF THE INVENTION

The present invention resides in a method for mounting electronics packages using an adhesive that can be removed and reworked at room temperature, thus minimizing the risk of damage to the electronics components. Briefly, and in general terms, the method comprises the steps selecting an adhesive that has good electrical and thermal conductivity, and has a glass transition temperature below normal room temperature; cleaning the components to be bonded together; preparing the adhesive for use at room temperature; applying the adhesive to at least one surface to be bonded to another; applying pressure momentarily between the surfaces to be bonded together; and curing the adhesive to produce a thermally and electrically conductive bond.

In accordance with an important aspect of the invention the method further comprises the steps of separating the surfaces bonded together if a component must be removed for re-working or replacement; and removing excess adhesive material from the two surfaces by scraping and cleaning. More specifically, the step of separating includes attaching a component removal tool to the component to be removed and applying a torque to the component through the component removal tool, until the bonded surfaces are twisted apart. Alternatively, the step of separating includes attaching a component removal tool to the component to be removed, wherein the component removal tool has a cuffing edge aligned with a bondline between the bonded surfaces; and tightening the component removal tool to move the cutting edge through the adhesive material and thereby separate the surfaces.

It will be appreciated from the foregoing that the present invention represents a significant advance in electronics packaging techniques. In particular, the invention provides a technique for reversibly bonding components, such that the bond may be broken without applying heat or large mechanical forces to the components. Other aspects and advantages of the invention will become apparent from the following more detailed description, taken in conjunction with the accompanying drawings.

### BRIEF DESCRIPTION OF THE DRAWINGS

FIG. 1 is a cross-sectional view showing a pair of electronics packages mounted in conductive contact with a panel having adjacent heat pipes for thermal dissipation, in accordance with the principles of the present invention;
FIG. 2 is a graph showing the glass transition temperature for a conventional epoxy adhesive and an adhesive selected in the present invention; and
FIG. 3 is a simplified flowchart showing the steps followed in mounting and removing electronics packages in accordance with the invention.

### DESCRIPTION OF THE PREFERRED EMBODIMENT

As shown in the drawings for purposes of illustration, the present invention pertains to a method for mounting electronics packages in conductive contact with a heat sink of some kind. Prior to the present invention, the use of a thermally conductive adhesive for thermal mounting of an electronics package to a heat sink has involved a practically irreversible process. Removal of such a package for repair or re-working typically results in damage to or destruction of the package.

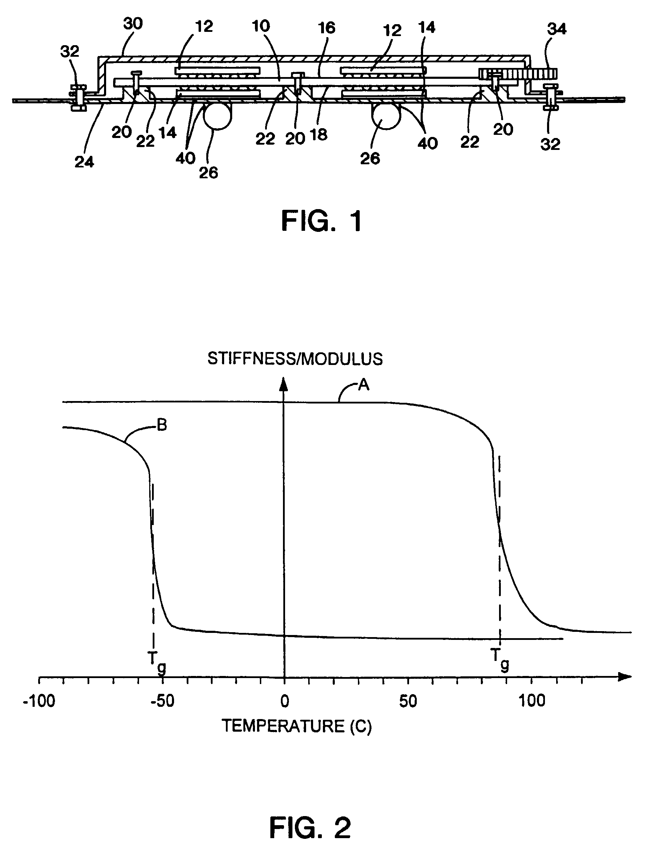

The present invention provides a completely reversible method for thermally mounting electronics packages, such that they can be removed for re-working without mechanical or heat damage. FIG. 1 depicts a packaging arrangement in which a circuit board, indicated by reference numeral 10, has electronics packages 12 and 14 mounted on upper and lower faces 16 and 18, respectively, and electrically connected to wiring on the circuit board. The circuit board 10 is itself mounted by mechanical fasteners 20 that extend into pedestals 22 on a conductive panel 24 that supports the board 10 and the packages 12 and 14. In the illustrative application, the panel 24 is in thermal contact with heat conducting pipes 26 that are used to dissipate heat generated in the electronics packages 12 and 14.

In the embodiment shown in FIG. 1, the packaging arrangement also includes a radiation shield in the form of an aluminum lid 30 covering the circuit board 10 and the electronics packages 12 and 14. The lid 30 is secured to the panel 24 by additional fasteners 32. An electrical connector 34 extends through the lid 30 and makes appropriate connections with components on the circuit board 10. In an important aspect of the invention, a specially selected adhesive 40 is placed between the lower electronics packages 14 and the panel 24, and may also be placed between the panel and the heat conducting pipes 26.

The adhesive 40 and the manner in which it is applied, are critical to the invention. Ideally, the adhesive 40 must have a combination of three desirable properties: thermal conductivity, electrical conductivity, and the ability to be re-worked (i.e. removed) at room temperature without damage to the electrical components. In addition, the adhesive should be relatively easy to apply.

Two polyurethane adhesives have been identified as having the desired combination of properties: (1) Aptek 2210 A/B, manufactured by Aptek Laboratories Inc., Valencia, California 91355, and (2) Uralane 7760, manufactured by Ciba Specialty Chemicals Corp., Performance Polymers, East Lansing, Michigan 48823. The Aptek 2210 A/B adhesive comes in two components that have to be mixed prior to use. The components are allowed to reach room temperature in unopened containers, and must be used very soon after mixing. The Uralane 7760 material is supplied in a premixed, frozen form, and is thawed at 100°F until ready for use. Before application of the adhesive, the component parts are thoroughly cleaned. Then the adhesive is applied within an appropriate pot life. For the two-part adhesive, the pot life is no more than thirty minutes. For premixed adhesive, the pot life is up to two hours. The adhesive must be applied in a manner that minimizes air entrapment and bondlines, and care is taken not to contact electrical leads or connectors on the printed circuit board 10. The adhesive is cured for four hours at 100°C, or for a much longer cure time at room temperature. As in many electronics fabrication and assembly processes, care must be taken to maintain a clean working environment, with operators wearing gloves or finger cots to minimize product contamination.

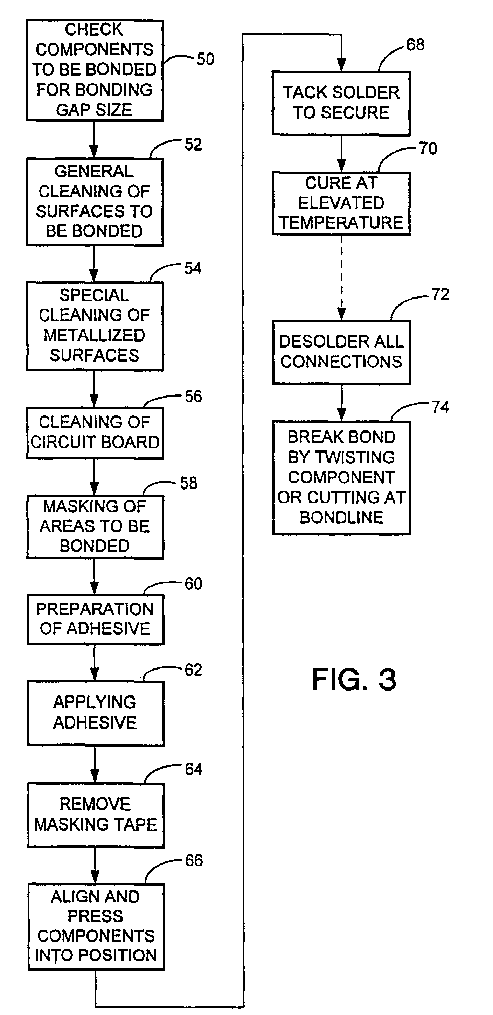

More specifically, the steps for installing components using one of these adhesives is as follows:
(1) The components to be bonded together are checked to make sure that there is an appropriately sized gap for installation of the adhesive, as indicated in block 50 of FIG. 3.
(2) The components to be assembled are first subject to a general cleaning, as indicated in block 52. The surfaces to be bonded are cleaned thoroughly by wiping at least twice with paper wipes or cotton swabs dampened with isopropyl alcohol, and the surfaces are examined to verify that they are free of foreign materials such as oil and dirt. Then the components are oven dried for a minimum of 30 minutes at a temperature of 150°F ± 10°F (65°C ± 5°C).
(3) Component parts with metallized surfaces are subjected to additional cleaning steps, as indicated in block 54, using a vapor degreaser and rinsing with de-ionized water. A water break free test is performed to make sure all greases and similar substances have been removed. Single drops of deionized water are placed at various locations to make sure that the water spreads and wets the surface uniformly. Otherwise, the cleaning steps are repeated.
(4) Each circuit board is similarly cleaned, as indicated in block 56, with wet paper wipes and de-ionized water. A water break free test is also performed on each circuit board.
(5) Components and the circuit board are then masked to define the areas to be bonded, as indicated in block 58. The masking tape is built up to the thickness desired for the adhesive layer.
(6) The adhesive is prepared, as indicated in block 60. Specifically, the adhesive is mixed, if necessary, and brought to room temperature.
(7) The adhesive is applied, as indicated in block 62, using a straightedge to spread a coating of the adhesive material flush with the surface of the tape, and taking care to minimize air entrapment. The masking tape is then carefully removed, as indicated in block 64, without the use of solvents. The component to be bonded is placed, carefully aligned, and pressed into position, as indicated in block 66, to ensure a good interface, but taking care not to have the bonding material squeeze out and form a fillet. If squeeze-out material forms a fillet, it can either be removed immediately, or first subjected to a one-hour cure at 210°F ± 10°F (100°C ± 5°C) to produce a partially hardened material, the excess of which can be scraped off with a stick, cotton swab, or other non-abrasive tool.
(8) Each component is tack soldered, as indicated in block 68, to attach any two diagonally opposite leads to the connector pads of the component, and thereby inhibit movement during curing.
(9) The adhesive is cured, as indicated in block 70, for 4 hours minimum in an oven maintained at 210°F ± 10°F (100°C ± 5°C).

Should it become necessary to remove a component that has been bonded in accordance with the foregoing procedure, all soldered connections are first desoldered, as indicated in block 72. Then a component removal tool is placed over the component to be removed and clamped in place. In one embodiment of the method, as indicated in block 74, the removal tool is then twisted carefully in one direction, using a torque wrench to ensure that the applied torque does not exceed 80 inch-pounds. After the bond is broken and the component has been removed, excess adhesive material is scraped off using a sharpened stick or a heat gun. The surfaces have to be cleaned of loose particles prior to a subsequent attempt to bond the components.

An alternative bonding removal technique is to use a tool that cuts through the bondline, as also indicated in block 74. Again, the excess adhesive has to be removed and the parts cleaned again prior to another attempt to bond the parts together.

The adhesive materials specified above are impregnated or loaded with silver particles to provide electrical and thermal conductivity. The quality of the adhesives that permits such easy removal of the components for re-working is that they have a very low stiffness or modulus or elasticity at room temperature. As shown in curve A of FIG. 2, a conventional two-part epoxy adhesive remains uniformly stiff, and therefore hard to work, until a temperature of approximately 90°C is reached. At a critical temperature, referred to as the glass transition temperature T_{g}, the stiffness of the material drops by a factor of approximately ten. Therefore, reworking or removing components that have been bonded with conventional adhesives requires an elevated temperature in excess of 100°C. As shown in curve B of FIG. 2, the adhesive used in the present invention has a glass transition temperature in the region of -60°C to -40°C. At room temperature, the adhesive may, therefore, be removed by either of the methods mentioned above. It will be understood that a low stiffness or modulus of elasticity means that the material may be strained, i.e. stretched, without imposing a large stress on the material. Stated another way, the material can be stretched by the application of very small forces and, therefore, easily removed without applying potentially damaging stress to the components being removed.

It will be appreciated from the foregoing that the present invention represents a significant advance in the field of electronics packaging. In particular, the invention provides a technique for reversibly bonding components to an underlying panel, such as a heat conducting panel. Because of the nature of the adhesive used for bonding, components may be easily removed for replacement or re-working. It will also be appreciated that, although the invention has been described in detail for purposes of illustration, various modifications may be made without departing from the spirit and scope of the invention. Accordingly, the invention should not be limited except as by the appended claims.

## Claims

1. A method for reversibly bonding electronic packages to an underlying panel, the method comprising the steps of:
selecting an adhesive that has good electrical and thermal conductivity, and has a glass transition temperature below normal room temperature;
cleaning the components to be bonded together;
preparing the adhesive for use at room temperature;
applying the adhesive to at least one surface to be bonded to another;
applying pressure momentarily between the surfaces to be bonded together; and
curing the adhesive to produce a thermally and electrically conductive bond.

2. A method as defined in claim 1, and further comprising the steps of:
separating the surfaces bonded together if a component must be removed for re-working or replacement; and
removing excess adhesive material from the two surfaces by scraping and cleaning.

3. A method as defined in claim 2, wherein the step of separating includes:
attaching a component removal tool to the component to be removed; and
applying a torque to the component through the component removal tool, until the bonded surfaces are twisted apart.

4. A method as defined in claim 2, wherein the step of separating includes:
attaching a component removal tool to the component to be removed, wherein the component removal tool has a cutting edge aligned with a bondline between the bonded surfaces; and
tightening the component removal tool to move the cutting edge through the adhesive material and thereby separate the surfaces.
